# DEMANDE DE BREVET EUROPEEN

(11) **EP 4 375 880 A1**
(43) Date de publication de la demande: **29.05.2024**
(21) Numéro de dépôt: 23211296.1
(22) Date de dépôt: 21.11.2023
(51) Int. Cl.: G06N 3/049, G06N 3/067, H01S 5/14, H01S 3/102, H01S 3/106, H01S 5/40, H01S 5/04

(54) **DISPOSITIF LASER IMPULSIONNEL COMPORTANT UNE SOURCE LASER HYBRIDE A DECLENCHEMENT OPTIQUE ACTIF**

(30) Priorité: 23.11.2022 FR 2212211
(71) Demandeur: Commissariat à l'Énergie Atomique et aux Énergies Alternatives, 75015 Paris (FR)
(72) Inventeur: MEKEMEZA, Ona Keshia, 38054 Grenoble cedex 09 (FR); CHARBONNIER, Benoit, 38054 Grenoble cedex 09 (FR)
(74) Mandataire: Brevalex

(57) **Abrégé**

L'invention porte sur un dispositif laser impulsionnel comportant :
o une source laser impulsionnelle 10 hybride de type III/V sur silicium, comportant une section à gain 12 et une section absorbante saturable 13 qui reposent sur un substrat photonique 20, et un guide d'onde longitudinal 21 situé dans le substrat photonique 20 ;
o un dispositif optique de commande 30, 40, comportant une source émettrice 31, 41 d'impulsions optiques et un guide d'onde latéral 32, 42 situé dans le substrat photonique 20 ;
o les guides d'onde 21, 32, 42 étant dimensionnés de sorte que le facteur de confinement Γ_{Iae/SA}, Γ_{Iai/G} dans les puits quantiques de la section correspondante 13, 12, du mode optique du guide d'onde latéral 32, 42, est supérieur au facteur de confinement Γ_{L/ms}, dans les puits quantiques du milieu semiconducteur 11, du mode optique du guide d'onde longitudinal 21.

## Description

### DOMAINE TECHNIQUE

Le domaine de l'invention est celui de la photonique neuromorphique à base de réseaux de neurones impulsionnels. L'invention porte plus précisément sur un dispositif laser impulsionnel pouvant former un neurone photonique, et comportant une source laser impulsionnelle.

### ÉTAT DE LA TECHNIQUE ANTÉRIEURE

Le calcul neuromorphique est actuellement en fort développement, notamment pour répondre aux attentes du traitement intensif de données. Pour cela, les réseaux de neurones artificiels (ANN pour *Artificial Neural Network*) ont montré leur puissance et leur efficacité. De tels neurones artificiels peuvent être réalisés à partir de sources laser impulsionnelles sur des puces photoniques, de sorte que l'on parle de photonique neuromorphique et de neurones photoniques impulsionnels (*spiking photonic neuron,* en anglais).

Une présentation générale des neurones photoniques impulsionnels peut se trouver notamment dans l'article de Shastri et al. intitulé Principles of Neuromorphic Photonics, arXiv:1801.00016, 2018. Un neurone photonique impulsionnel peut comporter : un ensemble de ports d'entrée, fournissant chacun un signal d'entrée xᵢ avec i allant de 1 à m, chaque signal d'entrée xᵢ étant pondéré par un poids wᵢ de signe positif ou négatif ; et un combineur effectuant la somme des signaux d'entrée pondérés wᵢxᵢ, associé à une fonction d'activation. Le neurone artificiel fournit un signal de sortie y lorsque la somme des signaux d'entrée pondérés dépasse un seuil prédéfini. Dans le cas des neurones photoniques impulsionnels, le signal de sortie est une impulsion optique (*spike* en anglais). A la suite de l'émission d'une impulsion optique par le neurone photonique impulsionnel, celui-ci entre dans une période dite réfractaire (*refractory period,* en anglais), dans laquelle il n'émet pas d'impulsions optiques de sortie, quels que soient les signaux d'entrée.

De tels neurones photoniques impulsionnels peuvent être classés en deux catégories : une première catégorie dite 'tout optique' dans laquelle les signaux d'entrée restent dans le domaine optique jusqu'à la source laser ; et une deuxième catégorie dite 'optique/électrique/optique' (O/E/O) dans laquelle les signaux d'entrée passent du domaine optique au domaine électrique, pour revenir au domaine optique.

L'article de Robertson et al. intitulé Ultrafast optical intégration and pattern classification for neuromorphic photonics based on spiking VCSEL neurons, Sci Rep. 2020 Apr 8;10:6098 décrit un neurone photonique impulsionnel de type tout optique. Il est formé d'une source laser à cavité verticale émettant par la surface (VCSEL pour *Vertical Cavity Surface Emitting Laser* en anglais) couplée à une source laser d'excitation. L'impulsion optique d'excitation doit présenter une longueur d'onde décalée vis-à-vis de celle de la longueur d'onde de la cavité optique de la source VCSEL. De plus, les impulsions optiques d'excitation doivent être inversées, dans le sens où c'est la diminution brutale de la puissance optique incidente qui peut provoquer l'excitation du neurone que forme la source VCSEL. Ce neurone photonique impulsionnel présente donc l'inconvénient de nécessiter plusieurs dispositifs optoélectroniques pour l'inversion des impulsions optiques, ainsi que pour le contrôle strict de l'écart entre les longueurs d'onde.

Par ailleurs, l'article de Peng et al. intitulé Neuromorphic Photonic Integrated Circuits, IEEE J. Sel. Topics Quantum Electron., vol. 24, no. 6, 2018, décrit un neurone photonique impulsionnel de type O/E/O. Celui-ci comporte une source laser impulsionnelle à rétroaction distribuée (DFB pour *Distributed Feedback*) dont le milieu semiconducteur comporte deux sections électriquement isolées l'une de l'autre, à savoir une section à gain (milieu à gain) et une section de type à absorbant saturable. Le déclenchement de la source laser est alors commandé à partir d'impulsions optiques converties en impulsions électriques par une paire de photodiodes puis injectées dans la section à gain. Ces impulsions électriques forment des signaux synaptiques excitateurs ou inhibiteurs. Cependant, les conversions O/E peuvent générer des pertes supplémentaires qui peuvent réduire la bande passante du neurone photonique impulsionnel ainsi que l'intensité ou la puissance de l'impulsion laser émise. De plus, les paires de photodiodes complexifient le circuit de déclenchement et réduisent la densité surfacique du réseau de neurones photoniques.

On connaît également l'article scientifique de Uenohara et al. intitulé Operation Characteristics of a Side-Light-Injection Multiple-Quantum-Well Bistable Laser for All-Optical Switching, Jpn. J. appl. Phys. Vol. 33 (1994), pp.815-821. Cependant, il porte sur un laser bistable et non pas sur un laser impulsionnel.

On connaît également l'article scientifique de Mekemeza-Ona et al. intitulé All optical Q-switched laser based spiking neuron, Front. Phys. 10:1017714 (2022) qui décrit un dispositif laser impulsionnel en technologie III-V sur silicium.

### EXPOSÉ DE L'INVENTION

L'invention a pour but de remédier au moins en partie aux inconvénients de l'art antérieur, et de proposer un dispositif laser impulsionnel comportant une source laser impulsionnelle hybride en technologie III-V sur silicium, formant un neurone artificiel photonique à déclenchement actif optique (i.e. tout optique) et présentant des performances optimisées.

Pour cela, l'objet de l'invention est un dispositif laser impulsionnel comportant une source laser impulsionnelle et au moins un dispositif optique de commande.

La source laser impulsionnelle est une source laser hybride de type III-V sur silicium. Elle comporte un milieu semiconducteur comportant des puits quantiques, réalisé à base d'un composé III-V, situé dans une cavité optique définissant un axe longitudinal, et comportant au moins une section à gain et au moins une section absorbante saturable où les puits quantiques sont coplanaires.

La source laser comporte également un substrat photonique, réalisé à base de silicium, sur lequel repose le milieu semiconducteur, et dans lequel est situé un guide d'onde longitudinal participant à définir la cavité optique et couplé optiquement au milieu semiconducteur suivant l'axe longitudinal, le guide d'onde longitudinal présentant une largeur l_{L/ms} et un espacement vertical d_{L/ms} vis-à-vis du milieu semiconducteur, dans une zone de couplage zc_{L/ms} avec le milieu semiconducteur, prédéfinis de sorte que le mode optique se propageant dans le guide d'onde longitudinal présente un facteur de confinement Γ_{L/ms} dans les puits quantiques du milieu semiconducteur.

Par ailleurs, le dispositif optique de commande, comporte : au moins une source émettrice adaptée à émettre au moins une impulsion optique de commande d'intensité prédéfinie; et au moins un guide d'onde latéral.

Le guide d'onde latéral est situé dans le substrat photonique, et est couplé optiquement à la section absorbante saturable ou à la section à gain pour transmettre l'impulsion optique de commande, de manière inclinée vis-à-vis de l'axe longitudinal pour éviter un couplage optique avec la cavité optique. Il présente une largeur ainsi qu'un espacement vertical vis-à-vis du milieu semiconducteur, dans une zone de couplage avec ladite section correspondante, prédéfinis de sorte que le mode optique se propageant dans le guide d'onde latéral présente un facteur de confinement dans les puits quantiques de ladite section correspondante supérieure à Γ_{L/ms·}

Par ailleurs, le guide d'onde longitudinal peut présenter une largeur I_{L/ms} dans sa zone de couplage zc_{L/ms}, et le guide d'onde latéral présente une largeur dans sa zone de couplage inférieure à l_{L/ms}.

Le guide d'onde longitudinal peut présenter un espacement vertical d_{L/ms} dans sa zone de couplage zc_{L/ms} vis-à-vis des puits quantiques du milieu semiconducteur, et le guide d'onde latéral peut présenter un espacement vertical dans sa zone de couplage vis-à-vis des puits quantiques du milieu semiconducteur, où l'espacement vertical d_{L/ms} est supérieur ou égal à celui du guide d'onde latéral.

Le guide d'onde longitudinal et le guide d'onde latéral peuvent être des guides d'onde en arête formés d'une base et d'une arête, la face inférieure du guide d'onde longitudinal et celle du guide d'onde latéral étant coplanaires.

Le guide d'onde longitudinal peut s'étendre continûment sous le milieu semiconducteur.

Le guide d'onde latéral peut s'étendre continûment sous la section correspondante ou comporte au moins un coupleur en pointe.

Le milieu semiconducteur peut comporter au moins deux sections à gain situées de part et d'autre de la section absorbante saturable.

La section à gain et la section absorbante saturable peuvent être des portions physiquement distantes l'une de l'autre, ou peuvent être des zones d'un même plot que forme le milieu semiconducteur.

Le dispositif optique de commande peut être un dispositif optique d'excitation, la source émettrice étant adaptée à émettre au moins une impulsion optique d'excitation d'intensité prédéfinie. Le guide d'onde latéral, dit d'excitation, peut alors être couplé optiquement à la section absorbante saturable. Le mode optique se propageant dans le guide d'onde latéral d'excitation présente alors un facteur de confinement Γ_{Iae/SA} dans les puits quantiques de la section absorbante saturable supérieure à Γ_{L/ms}.

Le dispositif optique de commande peut être un dispositif optique d'inhibition, la source émettrice étant adaptée à émettre au moins une impulsion optique d'inhibition d'intensité prédéfinie. Le guide d'onde latéral, dit d'inhibition, peut alors être couplé optiquement à la section à gain. Le mode optique se propageant dans le guide d'onde latéral d'inhibition présente alors un facteur de confinement Γ_{Iai/G} dans les puits quantiques de la section à gain supérieure à Γ_{L/ms}.

Le dispositif laser impulsionnel peut comporter un dispositif optique d'excitation et un dispositif optique d'inhibition.

Le dispositif laser impulsionnel peut comporter des atténuateurs d'intensité optique disposés sur les guides d'onde latéraux, et adaptés à diminuer l'intensité des impulsions optiques d'excitation et d'inhibition.

L'invention porte également sur un réseau de neurones artificiels photoniques, comportant une pluralité de dispositifs laser impulsionnels selon l'une quelconque des caractéristiques précédentes, dans lequel chaque source laser impulsionnelle forme un neurone artificiel photonique, les neurones artificiels photoniques étant raccordés optiquement les uns aux autres.

Dans ce réseau de neurones artificiels photoniques, un guide d'onde longitudinal d'un dispositif laser impulsionnel peut former un guide d'onde latéral d'excitation ou d'inhibition d'un autre dispositif laser impulsionnel.

L'invention porte également sur un procédé d'utilisation d'un dispositif laser impulsionnel selon l'une quelconque des caractéristiques précédentes, comportant les étapes suivantes :
- polarisation en direct de la section à gain par un courant électrique d'une intensité constante prédéfinie de sorte que le gain g du milieu semiconducteur atteigne une valeur maximale gₘₐₓ, et application d'une polarisation nulle ou en inverse de la section absorbante saturable ;
- émission d'une impulsion optique d'excitation par le dispositif optique d'excitation, provoquant une émission d'une impulsion laser par la source laser impulsionnelle si le gain est au moins égal à une valeur d'excitabilité g_{exc};
- émission d'une impulsion optique d'inhibition par le dispositif optique d'inhibition, empêchant l'émission d'une impulsion laser par une diminution de la valeur du gain en dessous de la valeur d'excitabilité g_{exc}.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
les figures 1A et 1B sont des vues schématiques et partielles, en perspective (fig.1A) et en coupe longitudinale (fig.1B), d'un dispositif laser impulsionnel selon un mode de réalisation ;
la figure 2 est une vue schématique et partielle d'un dispositif laser impulsionnel selon un mode de réalisation, formant un réseau de neurones artificiels photoniques ;
la figure 3 est un exemple d'évolution, en fonction de la largeur l du guide d'onde intégré, du facteur de confinement Γ d'un mode optique, circulant dans le guide d'onde intégré, dans les puits quantiques d'un milieu semiconducteur couplé optiquement au guide d'onde intégré ;
la figure 4A est une vue schématique et partielle, en coupe transversale, de la section à gain et du guide d'onde longitudinal selon un mode de réalisation, et les figures 4B et 4C sont des vues de dessus du guide d'onde longitudinal selon des exemples de réalisation ;
la figure 5A est une vue schématique et partielle, en coupe transversale, de la section absorbante saturable et du guide d'onde latéral d'excitation selon un mode de réalisation, et les figures 5B à 5D sont des vues de dessus du guide d'onde latéral selon des exemples de réalisation ;
les figures 6A et 6B sont des vues schématiques et partielles, en perspective (fig.6A) et de dessus (fig.6B), d'un dispositif laser impulsionnel selon un autre mode de réalisation, et la figure 6C est une vue en perspective d'un guide d'onde longitudinal et du guide d'onde latéral d'excitation illustrés sur la fig.6A et 6B.

### EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire.

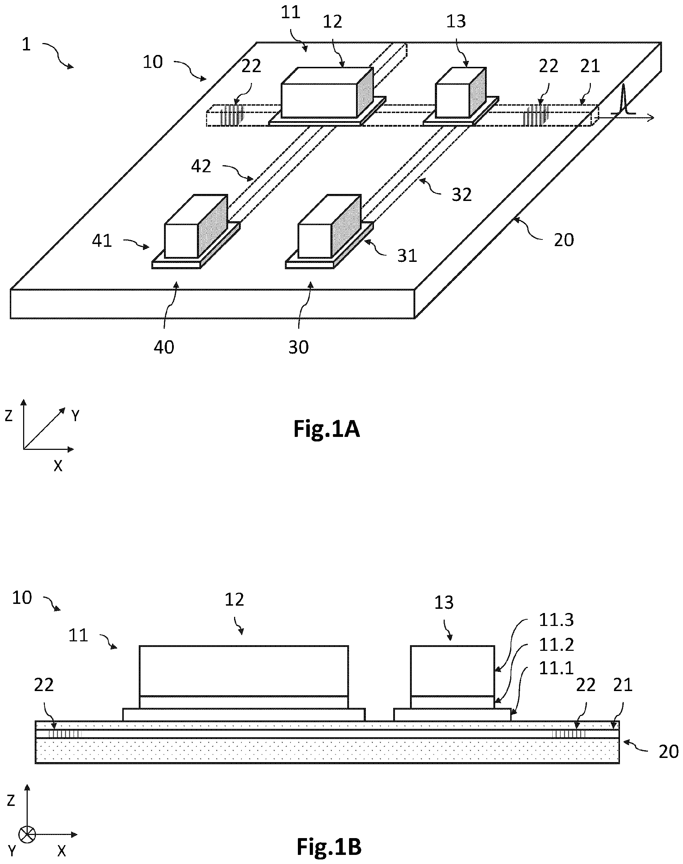

La figure 1A est une vue schématique et partielle, en perspective, d'un dispositif laser impulsionnel 1 selon un mode de réalisation, et la figure 1B est une vue en coupe longitudinale du milieu semiconducteur 11 et du guide d'onde longitudinal 21 illustrés sur la fig.1A.

On définit ici et pour la suite de la description un repère direct tridimensionnel orthogonal XYZ, où le plan XY est un plan parallèle au plan du substrat photonique 20, et où l'axe Z est orienté du substrat photonique 20 vers le milieu semiconducteur 11 de la source laser 10. Par ailleurs, les termes « inférieur » et « supérieur » s'entendent comme étant relatifs à un positionnement croissant lorsqu'on s'éloigne du substrat photonique 20 suivant la direction +Z.

Le dispositif laser impulsionnel 1 comporte *a minima* : une source laser 10, impulsionnelle, et hybride de type III/V sur silicium ; et au moins un dispositif optique de commande 30, 40, adapté à provoquer ou à inhiber l'émission d'une impulsion laser par la source laser 10.

La source laser 10 est dite impulsionnelle dans la mesure où elle est adaptée à émettre des impulsions laser. Elle est à déclenchement actif de manière optique puisque l'émission de l'impulsion laser est déclenchée ou évitée par le biais d'impulsions optiques d'excitation et d'inhibition qui sont transmises directement jusqu'à la source laser 10, sans passer par des photodiodes assurant une conversion O/E. Le déclenchement de l'émission laser ne se fait donc pas par la modulation du courant électrique de pompe. Cette source laser 10 appartient ainsi à la catégorie 'tout optique' des sources laser impulsionnelles à mode déclenché.

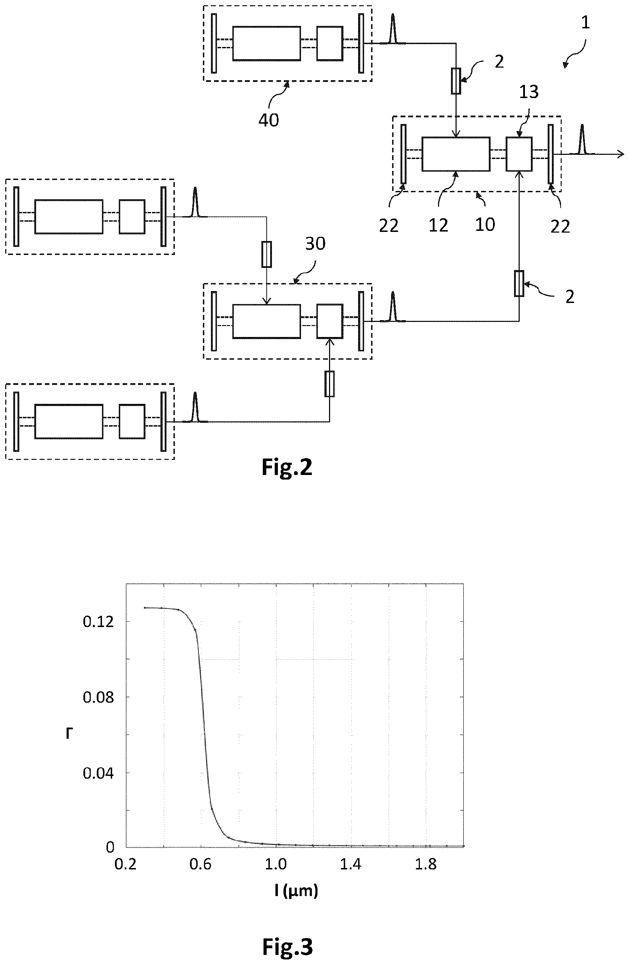

Ce dispositif laser impulsionnel 1 est ici une partie d'un réseau de neurones artificiels photoniques (cf. fig.2). Plus précisément, la source laser 10 forme un neurone artificiel photonique. Les guides d'onde latéraux 32, 42 sont les synapses et assurent la transmission des signaux synaptiques d'excitation et d'inhibition jusqu'à la source laser 10. Comme détaillé par la suite, la source laser 10 présente des propriétés propres aux neurones physiologiques, telles que les propriétés d'excitabilité et de période réfractaire (décrites plus loin).

La source laser 10 est dite hybride de type III/V sur silicium, dans le sens où elle comporte un milieu semiconducteur 11 réalisé à base d'un composé III-V reposant sur un substrat photonique 20 réalisé à base de silicium. La cavité optique est délimitée ici par deux réflecteurs optiques 22, ici des miroirs de Bragg (source laser de type à réflecteurs de Bragg répartis, DBR pour *Distributed Bragg Reflector,* en anglais), situés dans un guide d'onde intégré 21 dit longitudinal disposé dans le substrat photonique 20. Toutefois, la cavité optique peut également être de type à rétroaction distribuée (DFB pour *Distributed Feedback,* en anglais) où un même réseau de Bragg s'étend dans le guide d'onde longitudinal 21 sur toute la longueur de la cavité optique, voire être de type en anneau, ou à miroirs à boucle de Sagnac. La cavité optique définit un axe longitudinal X suivant lequel s'étend le guide d'onde longitudinal 21.

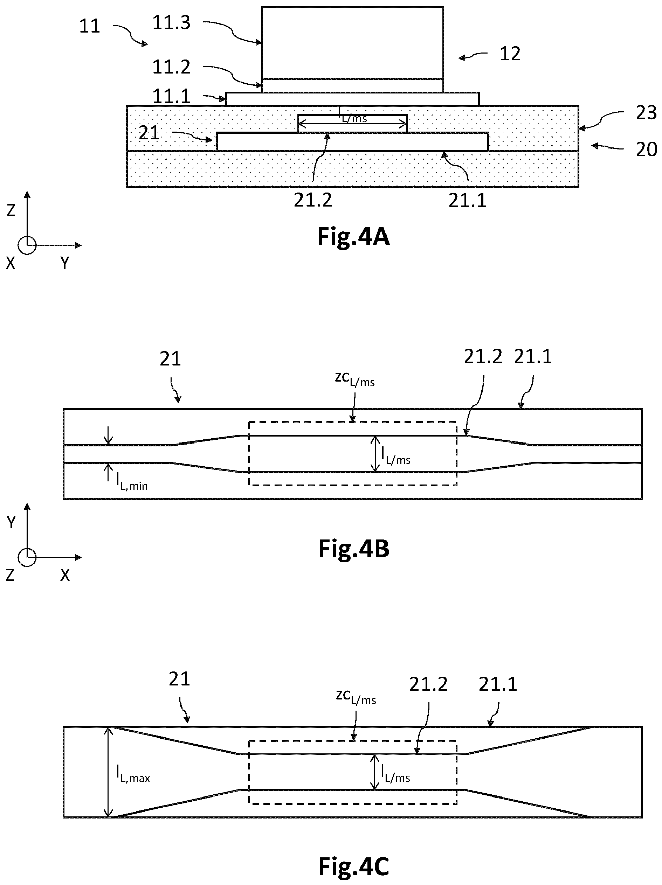

Le substrat photonique 20 est formé d'un substrat support, et de guides d'onde intégrés 21, 32, 42 dans le substrat support. Il peut comporter d'autres composants optiques passifs (multiplexeurs ou démultiplexeurs, coupleurs à fibre optique...) et/ou des composants optiques actifs (modulateurs...), optiquement couplés les uns aux autres de manière à former un circuit photonique intégré. Le substrat photonique 20 peut être de type SOI, c'est-à-dire qu'il peut comporter une couche mince de silicium et un substrat support en silicium, entre lesquelles est intercalée une couche d'oxyde dite BOX (*buried oxide,* en anglais). Les guides d'onde 21, 32, 42 peuvent comporter un coeur réalisé en silicium et une gaine réalisée en un oxyde de silicium. Dans cet exemple, les guides d'onde intégrés 21, 32, 42 sont, de préférence au moins dans une zone de couplage avec le milieu semiconducteur 11, des guides en arête formés d'une arête (*rib,* en anglais) reposant sur une base (*slab,* en anglais). Le guide d'onde longitudinal 21 est espacé du milieu semiconducteur 11 par une couche 23 d'oxyde de silicium d'une épaisseur locale e_{gap} de préférence constante. Sur la fig.4A, la base est notée 21.1 et l'arête est notée 21.2.

Le milieu semiconducteur 11 repose sur le substrat photonique 20 et est situé dans la cavité optique. Il est couplé optiquement au guide d'onde longitudinal 21 au-dessus duquel il est situé. Il est réalisé en un composé semiconducteur, ici de type III-V. Le terme III-V fait référence aux colonnes III et V du tableau périodique des éléments. Dans cet exemple, il comporte une couche semiconductrice 11.2 contenant des puits quantiques multiples, par exemple réalisés en InGaAsP ou de AIGaInAs avec un maximum de gain par exemple centré sur la longueur d'onde de l'impulsion laser. La couche de puits quantiques 11.2 est encadrée suivant l'axe vertical Z par des couches semiconductrices dopées, par exemple réalisées en InP, ici par une couche inférieure 11.1 dopée n et par une couche supérieure 11.3 dopée p. Aussi, le milieu semiconducteur 11 comporte une jonction PIN qui s'étend longitudinalement dans le plan XY. Le milieu semiconducteur 11 forme un guide d'onde dit actif couplé optiquement au guide d'onde longitudinal 21.

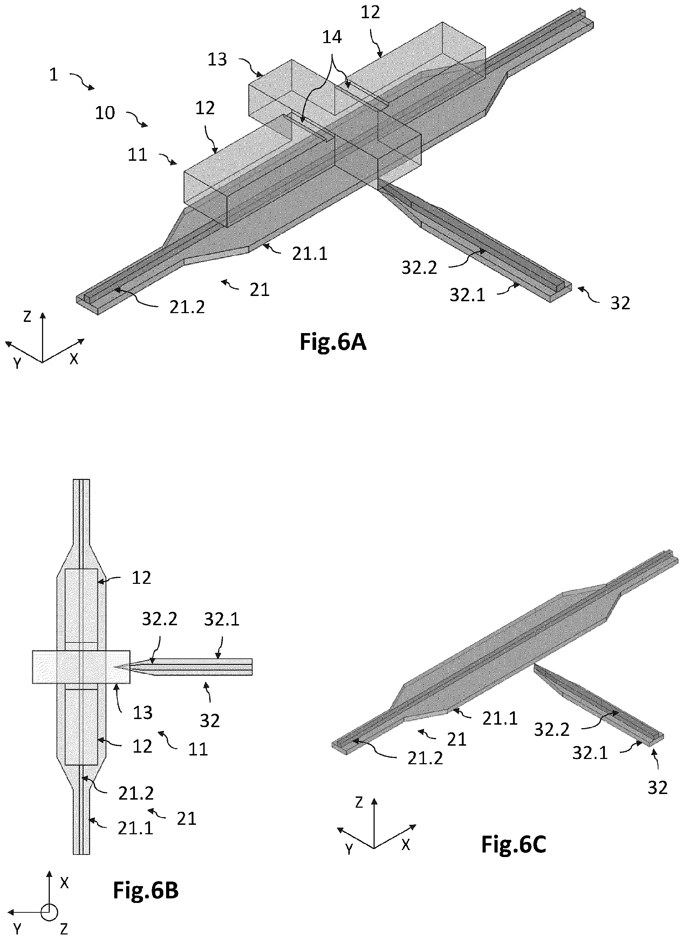

Le milieu semiconducteur 11 est formé d'au moins une section à gain 12 (amplification optique) et d'au moins une section absorbante saturable 13. Dans cet exemple, le milieu semiconducteur 11 comporte une section à gain 12 et une section absorbante saturable 13, mais elle peut comporter deux sections à gain situées de part et d'autre d'une section absorbante saturable 13 (cf. fig.6A), voire davantage. Elle peut comporter davantage de sections à gain et de sections absorbantes saturables. Ces sections 12, 13 sont agencées relativement l'une à l'autre sur l'axe longitudinal X de la cavité optique. De plus, elles sont électriquement isolées l'une de l'autre de sorte que le pompage électrique d'une section ne modifie pas la densité de porteurs libres de l'autre section. Enfin, ces sections peuvent être des plots physiquement séparés les uns des autres (cf. fig.1A et 1B), ou peuvent être des zones électriquement isolées d'un même plot (cf. fig.6A et 6B).

La section à gain 12 est le lieu principal de l'amplification optique du mode optique présent dans la cavité optique. Elle est formée du milieu à gain de la source laser 10, formé ici par le composé semiconducteur à base d'InP. Elle est connectée électriquement à une source électrique de polarisation (non représentée), qui assure la polarisation en direct de la section à gain 12. L'intensité du courant de pompe est définie de sorte que le gain g du milieu semiconducteur 11 atteigne, en régime stationnaire, une valeur maximale constante gₘₐₓ. Le gain g est, de manière connue, corrélé à la densité n_{G} de porteurs libres injectés dans la section à gain 12 par la source électrique (pompage électrique). Par ailleurs, le régime stationnaire correspond, comme détaillé plus loin, au régime où le gain est maximal et constant et où aucune impulsion optique n'est reçue par la section à gain 12 et par la section absorbante saturable 13 (les pertes optiques dans la cavité optique sont alors suffisamment élevées pour empêcher l'émission d'une impulsion laser). Ici, les pertes optiques sont essentiellement associées au coefficient de transmission du matériau de la section absorbante saturable 13.

La section absorbante saturable 13 présente une fonction d'obturateur optique commandable. De manière connue, un absorbant saturable est un milieu dont le coefficient de transmission optique, à la longueur d'onde de l'émission laser, varie en fonction de l'intensité optique incidente. Ainsi, la transmission est faible voire négligeable aux faibles intensités optiques incidentes, tandis qu'elle est élevée aux fortes intensités optiques (le matériau devient alors transparent). La section absorbante saturable 13 peut alors occuper deux états principaux et un état intermédiaire :
- un état au repos, dit état bloquant, lorsque l'intensité optique incidente est faible. Dans cet état, le coefficient de transmission est faible de sorte que les pertes optiques dans la cavité optique sont élevées, au moins égales à une valeur αₘₐₓ prédéfinie ;
- un état passant, lorsque l'intensité optique incidente est élevée. Dans cet état, le coefficient de transmission est élevé (le matériau est transparent à la longueur d'onde de l'émission laser) de sorte que les pertes optiques sont faibles, au plus égales à une valeur αₘᵢₙ prédéfinie. On dit que le matériau est saturé.
- un état intermédiaire, pour lequel les pertes optiques sont comprises entre αₘᵢₙ et αₘₐₓ (valeurs non inclus). Le matériau est alors soumis à un faisceau lumineux incident, mais n'est pas saturé.

Dans cet exemple, la section absorbante saturable 13 présente une hétérostructure semiconductrice identique à celle de la section à gain 12 en termes de matériau, de dopage, et d'épaisseur des couches. Aussi, les puits quantiques de la section à gain 12 et ceux de la section absorbante saturable 13 sont coplanaires. Par ailleurs, la section absorbante saturable 13, à la différence de la section à gain 12, n'est pas polarisée en direct, mais est polarisée soit en inverse soit avec une différence de potentiel nulle. Enfin, elle présente avantageusement une longueur, suivant l'axe longitudinal X, inférieure à celle de la section à gain 12 (et le cas échéant à la longueur cumulée des sections à gain), et de préférence présente une longueur comprise entre 2% et 10% environ de cette longueur cumulée. Ainsi, la section absorbante saturable 13 présente une dynamique de saturation/désaturation propice à l'émission d'impulsions laser particulièrement courtes et intenses.

A titre d'exemple, l'hétérostructure semiconductrice de la section à gain 12 et de la section absorbante saturable 13 est formée d'une couche semiconductrice inférieure 11.1 en InP dopé n d'une épaisseur de 150nm. Elle comporte une couche semiconductrice 11.2 à puits quantiques à base de AIGaInAs d'une épaisseur de 300nm, et une couche semiconductrice supérieure 11.3 en InP d'une épaisseur de 2µm environ. La longueur de la section à gain 12 peut être égale à 600 µm et celle de la section absorbante saturable 13 peut être égale à 20 µm.

La source électrique de polarisation (non représentée) assure donc la polarisation en direct de la section à gain 12 (pompage électrique) et applique ici une polarisation nulle à la section absorbante saturable 13 (I_{SA}=0mA). En variante, elle peut lui appliquer une polarisation en inverse. La source électrique transmet un courant électrique continu dans la section à gain 12 dont l'intensité est prédéfinie de sorte que le gain tend vers une valeur stationnaire maximale gₘₐₓ du gain. Cette valeur maximale gₘₐₓ est inférieure aux pertes optiques αₘₐₓ lorsque la section absorbante saturable 13 occupe l'état bloquant (ici lorsqu'elle n'est pas éclairée par une impulsion optique provenant du dispositif optique d'excitation 30 et de puissance suffisante pour rendre la section 13 transparente), de manière à éviter l'émission d'un signal laser continu.

Ainsi, à titre d'exemple, le courant électrique de seuil peut être égal à 16mA, valeur pour laquelle le gain gₜₕ (supérieur à la valeur gₘₐₓ) équilibre les pertes optiques élevées αₘₐₓ de la section absorbante saturable 13 à l'état bloquant, provoquant ainsi l'émission d'une succession d'impulsions laser. Aussi, pour être en mesure de « déclencher » de manière active l'émission d'une impulsion laser, on définit la valeur du courant électrique de pompe à une valeur inférieure à ce courant de seuil, par exemple à 15mA environ, pour que la valeur maximale gₘₐₓ du gain en régime stationnaire soit bien inférieure à la valeur seuil gₜₕ et n'équilibre donc pas les pertes optiques maximales αₘₐₓ. En revanche, comme détaillé plus loin, la valeur gₘₐₓ du gain est suffisamment élevée pour être au moins égale aux pertes optiques αₘᵢₙ lorsque la section absorbante saturable 13 occupe l'état passant (ici lorsqu'elle est éclairée par une impulsion optique provenant du dispositif optique d'excitation 30).

Le dispositif laser impulsionnel 1 comporte un ou plusieurs dispositifs optiques de commande 30, 40, et comporte dans cet exemple un dispositif optique d'excitation 30 et un dispositif optique d'inhibition 40. Il peut évidemment comporter plusieurs dispositifs optiques d'excitation 30 et/ou plusieurs dispositifs optiques d'inhibition 40.

Chaque dispositif optique de commande 30, 40 comporte : au moins une source émettrice 31, 41 adaptée à émettre au moins une impulsion optique de commande d'intensité prédéfinie ; et au moins un guide d'onde latéral 32, 42. Une même source émettrice peut être couplée à un ou plusieurs guides d'onde latéraux, et un même guide d'onde latéral peut être couplé à une ou plusieurs sources émettrices.

La source émettrice 31, 41 peut être située sur le substrat photonique 20 (comme illustré sur la fig.1A) mais en variante elle peut être située hors du substrat photonique 20 tout en étant couplée au guide d'onde latéral par un coupleur optique. Des éléments optiques actifs ou passifs (modulateur, multiplexeur, réseau de couplage...) peuvent être couplés au guide d'onde latéral, et être situés entre la source émettrice correspondante et le milieu semiconducteur 11.

Comme indiqué en détail plus loin, chaque guide d'onde latéral présente des propriétés dimensionnelles en termes de largeur et d'espacement vertical, dans une zone de couplage avec la section correspondante du milieu semiconducteur 11 (i.e. la section absorbante saturable 13 dans le cas de l'excitation, et la section à gain 12 dans le cas de l'inhibition), prédéfinies de sorte que le facteur de confinement du mode optique dans les puits quantiques de la section correspondante est supérieur au facteur de confinement du mode optique (se propageant dans le guide d'onde longitudinal 21) dans les puits quantiques du milieu semiconducteur 11.

Le dispositif optique d'excitation 30 comporte une source émettrice 31 adaptée à émettre une impulsion optique dite d'excitation, et un guide d'onde dit latéral 32 permettant de transmettre l'impulsion optique d'excitation jusqu'à la section absorbante saturable 13. Ce guide d'onde latéral 32 est intégré dans le substrat photonique 20 et est couplé optiquement à la section absorbante saturable 13 sans pour autant être couplé optiquement à la cavité optique. Pour cela, le guide d'onde latéral 32 est couplé à la section absorbante saturable 13 de manière inclinée dans le plan XY vis-à-vis de l'axe longitudinal X. Aussi, les photons de l'impulsion optique d'excitation, non absorbés par la section absorbante saturable 13, ne se propagent pas suivant l'axe longitudinal X dans la cavité optique. Dans cet exemple, l'angle d'inclinaison formée par le guide d'onde latéral 32 vis-à-vis de l'axe longitudinal X, au niveau de la section absorbante saturable 13, est par exemple compris entre 60° et 120°. Dans cet exemple, il est égal à 90° environ. De préférence, il est coplanaire au guide d'onde longitudinal 21 (il peut être issu d'une même couche mince en silicium monocristallin d'un substrat SOI), dans le sens où la face inférieure du guide d'onde latéral 32 est coplanaire à celle du guide d'onde longitudinal 21.

L'impulsion optique d'excitation présente une intensité optique prédéfinie et une longueur d'onde ici égale à la longueur d'onde de l'oscillation laser (comprise dans le spectre d'absorption de la section absorbante saturable 13). Elle peut provoquer l'émission d'une impulsion laser par la source laser 10 lorsque le gain présente sa valeur stationnaire maximale gₘₐₓ. Comme détaillée par la suite, le fait que le gain présente cette valeur maximale gₘₐₓ traduit le fait que la source laser 10 est effectivement en mesure d'émettre une impulsion laser : elle est alors suivie d'une période dite réfractaire (*refractory period,* en anglais) au cours de laquelle elle n'est pas en mesure d'émettre une impulsion laser, quand bien même elle aurait reçu une impulsion optique d'excitation.

Autrement dit, lorsque la section absorbante saturable 13 n'est pas éclairée par l'impulsion optique d'excitation, elle présente une transmission minimale se traduisant par des pertes optiques maximales αₘₐₓ. Le courant de pompe injecte une densité de porteurs libres dans la section à gain 12 se traduisant par, en régime stationnaire, une valeur maximale gₘₐₓ de gain. Cette valeur maximale gₘₐₓ est inférieure à une valeur seuil gₜₕ qui équilibrerait les pertes optiques maximales αₘₐₓ de la section absorbante saturable 13 et provoquerait l'émission d'un signal laser. Aussi, en régime stationnaire, la source laser 10 ne reçoit pas d'impulsion optique d'excitation et elle n'émet donc pas d'impulsion laser.

En revanche, lorsque la section absorbante saturable 13 est saturée, elle présente une transmission maximale, se traduisant par des pertes optiques minimales αₘᵢₙ. La valeur maximale gₘₐₓ du gain est alors au moins égale à la valeur minimale αₘᵢₙ des pertes optiques, de sorte que, lorsque la section à absorbante saturable est éclairée par l'impulsion optique d'excitation et qu'elle est saturée, la source laser 10 émet alors une impulsion optique.

Le dispositif laser impulsionnel 1 peut également comporter un dispositif optique d'inhibition 40. Celui-ci comporte une source émettrice 41 adaptée à émettre une impulsion optique dite d'inhibition, et un guide d'onde latéral 42 d'inhibition permettant de transmettre l'impulsion optique d'inhibition jusqu'à la section à gain 12. Ce guide d'onde latéral 42 est également intégré dans le substrat photonique 20 et est couplé optiquement à la section à gain 12 sans pour autant être couplé optiquement à la cavité optique. Pour cela, comme pour le guide d'onde latéral 32, le guide d'onde latéral 42 est couplé à la section à gain 12 de manière inclinée dans le plan XY vis-à-vis de l'axe longitudinal X. Aussi, les photons de l'impulsion optique d'inhibition ne se propagent pas suivant l'axe longitudinal X dans la cavité optique. Dans cet exemple, l'angle d'inclinaison est compris entre 60° et 120°, et est ici égal à 90° environ. De préférence, il est coplanaire au guide d'onde longitudinal 21 (il peut être issu d'une même couche mince en silicium monocristallin d'un substrat SOI), dans le sens où la face inférieure du guide d'onde latéral 42 est coplanaire à celle du guide d'onde longitudinal 21.

L'impulsion optique d'inhibition présente une intensité optique prédéfinie et ici une longueur d'onde égale à celle de l'oscillation laser. Elle peut permettre d'éviter l'émission d'une impulsion laser par la source laser 10. Pour cela, comme détaillé plus loin, une telle impulsion optique reçue par la section à gain 12 provoque une diminution de la valeur du gain, qui présente alors une valeur transitoire inférieure à la valeur maximale gₘₐₓ, mais également inférieure à une valeur g_{exc} dite d'excitabilité à partir de laquelle la source laser 10 peut émettre une impulsion laser lorsque la section absorbante saturable 13 reçoit l'impulsion optique d'excitation et qu'elle est saturée.

Autrement dit, lorsque le gain présente une valeur, en régime stationnaire, supérieure ou égale à la valeur d'excitabilité g_{exc}, mais inférieure à la valeur seuil gₜₕ (et donc inférieure aux pertes optiques maximales αₘₐₓ), la source laser 10 émet, ou non, une impulsion laser selon que la section absorbante saturable 13 reçoit, ou non, une impulsion optique d'excitation. En revanche, lorsque le gain présente une valeur transitoire inférieure à la valeur d'excitabilité g_{exc}, la source laser 10 n'émet pas une impulsion laser, quand bien même la section absorbante saturable 13 recevrait une impulsion optique d'excitation.

La figure 2 est une vue schématique et partielle d'un dispositif laser impulsionnel 1 selon un mode de réalisation où il correspond à un réseau de neurones artificiels photoniques. La source laser 10 forme un neurone artificiel photonique, qui est relié aux dispositifs optiques d'excitation 30 et d'inhibition 40 par les guides d'onde latéraux de ces derniers. Ces guides d'onde latéraux forment ainsi les synapses du neurone artificiel photonique 10. Dans cet exemple, les dispositifs optiques d'excitation 30 et d'inhibition 40 sont des sources laser impulsionnelles identiques ou similaires à celle du dispositif laser impulsionnel 1, et forment donc également des neurones artificiels photoniques.

L'ensemble est ici une partie d'un réseau de neurones artificiels photoniques à déclenchement actif de type 'tout optique', en configuration hybride III/V sur silicium où les différents guides d'onde sont intégrés dans le substrat photonique. Les impulsions optiques d'excitation sont donc des signaux synaptiques dont le poids est de signe positif et dont l'intensité peut être modifiée par les atténuateurs d'intensité optique. De même, les impulsions optiques d'inhibition sont donc des signaux synaptiques dont le poids est de signe négatif dont l'intensité peut être modifiée.

Notons que le dispositif laser impulsionnel 1 peut comporter des atténuateurs d'intensité 2 (cf. fig.2), couplés aux guides d'onde latéraux 32, 42, pour atténuer ou non l'intensité des impulsions optiques d'excitation et d'inhibition transmises. De tels atténuateurs 2 peuvent être des modulateurs de type Mach-Zehnder ou à anneau résonnant. Il peut également s'agir de matériaux à changement de phase choisi notamment parmi les chalcogénures, en particulier de type GST, c'est-à-dire formés à base de germanium Ge, d'antimoine Sb, et de tellure Te. On peut se référer au document de Abdollahramezani et al. intitulé Tunable nanophotonics enabled by chalcogenide phase-change materials, Nanophotonics 2020, 9(5), 1189-1241.

Dans la suite de la description, on note Γ_{L/ms} le facteur de confinement dans les puits quantiques du milieu semiconducteur 11 du mode optique qui se propage dans le guide d'onde longitudinal 21. De même, on note Γ_{Iae/SA} le facteur de confinement dans les puits quantiques de la section absorbante saturable 13 du mode optique qui se propage dans le guide d'onde latéral 32 d'excitation. Et enfin on note Γ_{Iai/G} le facteur de confinement dans les puits quantiques de la section à gain 12 du mode optique qui se propage dans le guide d'onde latéral 42 d'inhibition.

Le guide d'onde longitudinal 21, le guide d'onde latéral 32, et le guide d'onde latéral 42 présentent des propriétés dimensionnelles prédéfinies dans leurs zones de couplage respectives, de sorte que le facteur de confinement Γ_{Iae/SA} et le facteur de confinement Γ_{Iai/G} sont supérieurs au facteur de confinement Γ_{L/ms}.

Plus précisément, les propriétés dimensionnelles sont principalement la largeur l des guides d'onde intégrés et leur espacement vertical d vis-à-vis du milieu semiconducteur 11 (et donc vis-à-vis des puits quantiques de ce dernier). Le guide d'onde longitudinal 21 présente donc une largeur l_{L/ms} et un espacement vertical d_{L/ms}, lesquels sont définis dans une zone de couplage z_{L/ms} avec le milieu semiconducteur 11, de sorte que le mode optique circulant dans le guide d'onde longitudinal 21 présente un facteur de confinement Γ_{L/ms} dans les puits quantiques du milieu semiconducteur 11.

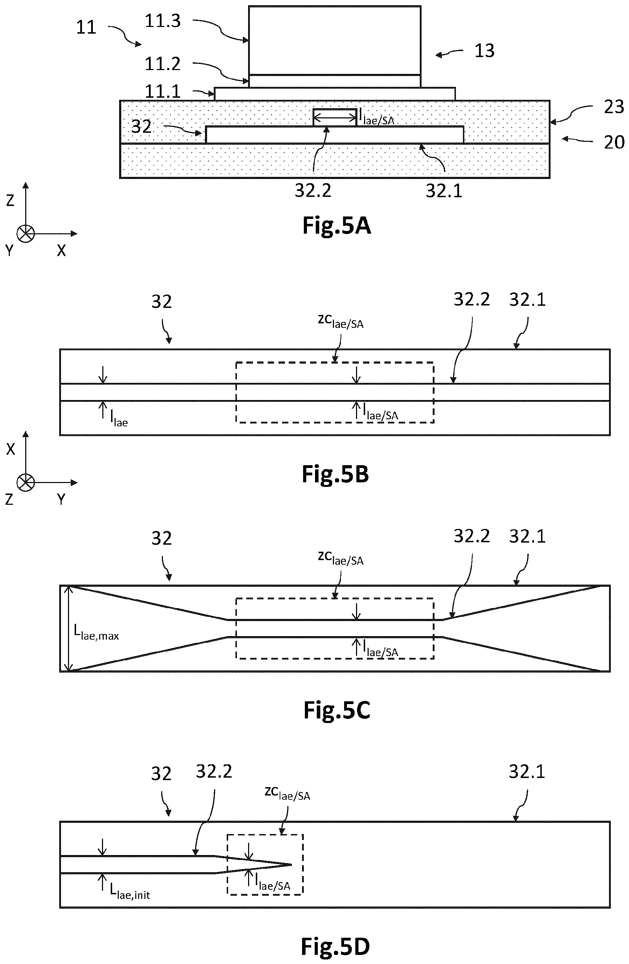

Les guides d'onde 21, 32, 42 peuvent être des guides d'onde en arête formés d'une base et d'une arête. L'arête peut être située du côté du milieu semiconducteur 11, comme illustré sur les fig.4A, 5A e t6A, mais en variante elle peut être située du côté opposé. La largeur l du guide d'onde est alors la distance, suivant un axe transversal dans le plan XY, entre les flancs latéraux de l'arête. Dans le cas d'un guide d'onde à section rectangulaire (pas d'arête), la largeur l est alors la distance transversale dans le plan XY entre les flancs du guide d'onde. Par ailleurs, l'espacement vertical d est la distance, suivant l'axe Z, entre la face supérieure du guide d'onde (dans le cas d'un guide en arête : face supérieure de l'arête ou de la base, en fonction de la position de l'arête) et la face inférieure du milieu semiconducteur 11.

De même, le guide d'onde latéral 32 présente donc une largeur l_{Iae/SA} et un espacement vertical d_{Iae/SA}, lesquels sont définis dans une zone de couplage z_{Iae/SA} avec la section absorbante saturable 13, tels que le mode optique circulant dans le guide d'onde latéral 32 présente un facteur de confinement Γ_{Iae/SA} dans les puits quantiques de la section absorbante saturable 13. La largeur l_{Iae/SA} et l'espacement vertical d_{Iae/SA} sont prédéfinis de sorte que Γ_{Iae/SA} est supérieur à Γ_{L/ms}, par exemple 10 fois supérieur.

Enfin, le guide d'onde latéral 42 présente une largeur l_{Iai/G} et un espacement vertical d_{Iai/G}, lesquels sont définis dans une zone de couplage z_{Iai/G} avec la section à gain 12, tels que le mode optique circulant dans le guide d'onde latéral 42 présente un facteur de confinement Γ_{Iai/G} dans les puits quantiques de la section à gain 12. La largeur l_{Iai/G} et l'espacement vertical d_{Iai/G} sont prédéfinis de sorte que Γ_{Iai/G} est supérieur à Γ_{L/ms}, par exemple 10 fois supérieur.

Cela permet alors d'améliorer les performances du dispositif laser impulsionnel 1. En effet, lorsque le mode optique circulant dans la cavité optique, et donc dans le guide d'onde longitudinal 21, présente un facteur de confinement Γ_{L/ms} dans les puits quantiques du milieu semiconducteur 11, qui est faible par exemple de l'ordre de 1 à 2%, le gain saturé de la source laser 10 est élevé, ce qui permet d'obtenir des impulsions laser de plus forte énergie. On cherche donc à ce que la valeur du facteur de confinement Γ_{L/ms} reste faible.

En revanche, lorsque les modes optiques des signaux de commande, i.e. ceux circulant dans les guides d'onde latéraux 32 et 42, présentent un facteur de confinement élevé dans les puits quantiques de la section absorbante saturable 13 (pour le mode optique circulant dans le guide 32) et dans ceux de la section à gain 12 (pour le mode optique circulant dans le guide 42), on optimise l'efficacité d'émission et l'efficacité d'inhibition. En effet, les photons injectés latéralement dans la section absorbante saturable 13 provoquent un maximum d'excitation de porteurs libres, ce qui augmente localement l'inversion de population, et donc fait saturer plus efficacement l'absorption. De même, les photons injectés latéralement dans la section à gain 12 provoquent un maximum d'émission stimulée, ce qui diminue localement l'inversion de population, et donc fait chuter efficacement le gain.

Dans cette configuration, le mode optique se propageant dans le guide d'onde longitudinal 21 présente un faible facteur de confinement Γ_{L/ms} dans les puits quantiques du milieu semiconducteur 11, alors que le mode optique se propageant dans le guide d'onde latéral 32 présente un facteur de confinement Γ_{Iae/SA} plus important dans les puits quantiques de la section absorbante saturable 13 (tout comme le guide d'onde latéral 42 qui présente un facteur de confinement Γ_{Iai/G} plus important).

Aussi, dans le cadre d'un dispositif laser impulsionnel 1 selon l'invention, où la source laser 10 présente une configuration III-V sur Si, il est possible d'optimiser les performances simplement, en ajustant la largeur I_{L/ms} et/ou l'espacement vertical d_{L/ms} du guide d'onde longitudinal 21 dans sa zone de couplage zc_{L/ms} avec le milieu semiconducteur 11, et en ajustant la largeur l_{lae/SA} et/ou l'espacement vertical d_{Iae/SA} du guide d'onde latéral 32 dans la zone de couplage zc_{Iae/SA}. De même, on peut ajuster la largeur l_{Iai/G} et/ou l'espacement vertical d_{Iai/G} du guide d'onde latéral 42 dans sa zone de couplage zc_{Iai/G} avec la section à gain 12. On profite ici du fait que les guides d'onde 21, 32 et 42 sont des guides d'onde intégrés dans le substrat photonique 20, et dont ces paramètres de largeur et d'espacement vertical peuvent être ajustés simplement, indépendamment du milieu semiconducteur 11.

De plus, le fait que le facteur de confinement Γ_{Iae/SA} et/ou Γ_{Iai/G} est supérieur à Γ_{L/ms} permet d'améliorer les performances du dispositif laser impulsionnel 1 par un effet conjoint, d'une part, d'une optimisation du gain saturé de la source laser 10 et des efficacités d'émission et/ou d'inhibition, et d'autre part, par une limitation des fuites par transfert optique liées à un fort recouvrement des modes optique longitudinal et latéraux.

En effet, sur ce dernier point, le fait d'avoir des facteurs de confinement Γ_{L/ms} et Γ_{Iae/SA} (et Γ_{Iai/G}) de même valeur se traduit par un recouvrement spatial local fort du mode optique longitudinal et du mode optique latéral au croisement entre ces modes optiques. Un tel recouvrement peut conduire à un transfert optique d'un mode vers l'autre *(crosstalk,* en anglais), conduisant à une dégradation des performances.

Aussi, le fait d'avoir des facteurs de confinement différent entre Γ_{L/ms} d'une part et Γ_{Iae/SA} et Γ_{Iai/G} d'autre part permet de réduire ce recouvrement spatial local des modes optiques et donc les risques de transfert entre les modes optiques ; et le fait d'avoir a fortiori Γ_{Iae/SA} ; Γ_{Iai/G} > Γ_{L/ms} permet d'optimiser à la fois le gain saturé et les efficacité d'émission et d'inhibition. Ainsi les performances du dispositif laser impulsionnel 1 sont optimisées.

De préférence, le ou les guides d'onde latéraux sont configurés de sorte que le facteur de confinement Γ_{Iae/SA}, comme le facteur de confinement Γ_{Iae/G}, présente un écart avec le facteur de confinement Γ_{L/ms} au moins égal à 5%, voire à 8%, voire encore à 10%. Ainsi, à titre d'exemple, si le facteur de confinement Γ_{L/ms} est égal à 1%, les facteurs de confinement Γ_{Iae/SA} et Γ_{Iai/G} sont au moins égal à 6%, voire à 9%, voire à 11%. Cela permet de réduire ce recouvrement spatial local des modes optiques.

La figure 3 illustre un exemple d'évolution du facteur de confinement Γ d'un mode optique, se propageant dans un guide d'onde intégré en arête, dans les puits quantiques du milieu semiconducteur 11, en fonction de la largeur l du guide d'onde, et ici de son arête.

Dans cet exemple, le milieu semiconducteur 11 comporte une portion inférieure 11.1 en InP dopé de type n d'une épaisseur de 150nm. La portion 11.2 est formée d'une partie inférieure de confinement en AIGalnAs d'une épaisseur de 90nm, d'une partie centrale à puits quantiques à base d'AlGaInAs d'une épaisseur de 120nm, et d'une partie supérieure de confinement en InGaAsP d'une épaisseur de 90nm. La portion supérieure 11.3 en InP dopé de type p présente une épaisseur de 2µm. Les portions 11.2 et 11.3 présentent une largeur de 5µm.

Par ailleurs, à titre d'exemple, le guide d'onde intégré est réalisé en silicium et est entouré d'un oxyde de silicium. Il est formé d'une base 21.1 d'une largeur de 15µm et d'une épaisseur de 300nm, et d'une arête 21.2 d'une largeur l à faire varier et d'une épaisseur de 200nm. Le guide d'onde est espacé verticalement du milieu semiconducteur 11 d'une distance de 100nm.

Le facteur de confinement Γ du mode optique dans les puits quantiques est déterminé par le logiciel Lumerical de simulation numérique des équations de l'électromagnétisme par le solveur de modes MODE-FDE. Il apparaît que le facteur de confinement Γ est une fonction décroissante avec la largeur l du guide d'onde, et présente une décroissance forte autour d'une valeur seuil, ici de l'ordre de 0.6µm. Aussi, il apparaît qu'il est possible, à la fois et simplement, d'ajuster la largeur l_{L/ms} du guide d'onde longitudinal 21 dans sa zone de couplage avec le milieu semiconducteur 11 pour que le facteur de confinement Γ_{L/ms} soit autour de 1 à 2%, et d'ajuster la largeur l_{Iae/SA} du guide d'onde latéral 32 dans sa zone de couplage avec la section absorbante saturable 13, et la largeur l_{Iai/G} du guide d'onde latéral 42 dans sa zone de couplage avec la section à gain 12, pour que les facteurs de confinement respectifs Γ_{Iae/SA} et Γ_{Iai/G} soient maximaux, et ici autour de 13%.

De préférence, l'espacement vertical d des guides d'onde intégrés 21, 32, 42 vis-à-vis du milieu semiconducteur 11 et donc vis-à-vis des puits quantiques sont identiques. Les guides d'onde latéraux 32, 42 présentent alors une largeur respective l_{Iae/SA} et l_{Iai/G} inférieure à la largeur I_{L/ms} du guide d'onde longitudinal 21. C'est ce qui est illustré sur les figures 4A-4C et 5A-5D. En variante ou en complément, l'espacement vertical respectif d_{Iae/SA} et d_{Iai/G} des guides d'onde latéraux 32, 42 peut être inférieur à l'espacement vertical d_{L/ms} du guide d'onde longitudinal 21.

La figure 4A est une vue schématique et partielle, en coupe transversale, de la section à gain 12 et du guide d'onde longitudinal 21. La largeur I_{L/ms} du guide d'onde longitudinal 21 est ici celle de son arête 21.2 dans la zone de couplage zc_{L/ms} dans la mesure où c'est ce paramètre qui impacte le facteur de confinement Γ_{L/ms}. L'arête 21.2 présente une face supérieure opposée à la base 21.1, et des flancs latéraux. Ces derniers sont ici sensiblement verticaux. Comme indiqué précédemment, la largeur I_{L/ms} est la distance transversale, suivant l'axe Y, entre les flancs latéraux de l'arête 21.2. L'espacement vertical d_{L/ms} est la distance suivant l'axe Z, définie dans la zone de couplage zc_{L/ms}, entre la face supérieure de l'arête 21.2 et la face inférieure du milieu semiconducteur 11. Dans cet exemple, d_{L/ms}, est égal à d_{Iae/SA} et à d_{Iai/G}.

La figure 4B est une vue schématique et partielle, en vue de dessus, du guide d'onde longitudinal 21 selon un exemple de réalisation. La zone de couplage avec le milieu semiconducteur 11 est représentée en trait pointillé. La section à gain 12 et la section absorbante saturable 13 sont donc situées dans cette zone de couplage zc_{L/ms}. Dans cet exemple, le guide d'onde longitudinal 21 présente une arête 21.2 d'une largeur constante minimale l_{L,min} dans les zones en amont et en aval de la zone de couplage zc_{L/ms}, cette largeur étant ici inférieure à la valeur l_{L/ms}. A titre d'exemple, la largeur l_{L} peut être égale à 400nm alors que la largeur I_{L/ms} peut ici être égale à 700nm. Le guide d'onde longitudinal 21 présente des zones intermédiaires où la largeur passe de la valeur l_{L,min} à la valeur l_{L/ms}.

La figure 4C est une vue schématique et partielle, en vue de dessus, du guide d'onde longitudinal 21 selon un autre exemple de réalisation. Dans cet exemple, le guide d'onde longitudinal 21 est un guide à section rectangulaire en amont et en aval de la zone de couplage. En effet, la largeur l_{L} de l'arête augmente à partir de la zone de couplage zc_{L/ms} jusqu'à atteindre la largeur de la base 21.1, par exemple ici 15µm. Le guide d'onde longitudinal 21 présente donc des zones intermédiaires où la largeur passe de la valeur maximale l_{L,max} à la valeur l_{L/ms}.

La figure 5A est une vue schématique et partielle, en coupe transversale, de la section absorbante saturable 13 et du guide d'onde latéral 32. La largeur l_{Iae/SA} du guide d'onde latéral 32 est ici celle de son arête 32.2 dans la zone de couplage zc_{Iae/SA}. L'arête 32.2 présente une face supérieure opposée à la base 32.1, et des flancs latéraux. Ces derniers sont ici également sensiblement verticaux. La largeur l_{Iae/SA} est la distance transversale, suivant l'axe X, entre les flancs latéraux de l'arête 32.2. L'espacement vertical d_{Iae/SA} est la distance suivant l'axe Z, définie dans la zone de couplage zc_{Iae/SA}, entre la face supérieure de l'arête 32.2 et la face inférieure de la section absorbante saturable 13 du milieu semiconducteur 11. Dans cet exemple, d_{L/ms} est égal à d_{Iae/SA} et à d_{Iai/G}.

La figure 5B est une vue schématique et partielle, en vue de dessus, du guide d'onde latéral 32 selon un exemple de réalisation. La zone de couplage zc_{Iae/SA} avec la section absorbante saturable 13 est représentée en trait pointillé (la section absorbante saturable 13 est donc située dans cette zone de couplage). Dans cet exemple, le guide d'onde latéral 32 présente une arête d'une largeur constante l_{Iae/SA} à la fois dans la zone de couplage zc_{Iae/SA} et dans les zones en amont et en aval. A titre d'exemple, la largeur l_{Iae/SA} peut être égale à 400nm.

La figure 5C est une vue schématique et partielle, en vue de dessus, du guide d'onde latéral 32 selon un autre exemple de réalisation. Dans cet exemple, il est un guide à section rectangulaire en amont et en aval de la zone de couplage zc_{Iae/SA}. En effet, la largeur de l'arête augmente à partir de la zone de couplage jusqu'à atteindre la largeur de la base 32.1, par exemple ici 15µm. Le guide d'onde latéral 32 présente des zones intermédiaires où la largeur passe de la valeur maximale l_{Iae,max} à la valeur l_{Iae/SA}.

La figure 5D est une vue schématique et partielle, en vue de dessus, du guide d'onde latéral 32 selon un autre exemple de réalisation. Dans cet exemple, il présente un coupleur en pointe (*taper* en anglais). En effet, la largeur de l'arête 32.2 passe ici d'une valeur initiale l_{Iae,init} à une valeur nulle. Cette variation de la largeur est adiabatique de sorte que le mode optique passe entièrement du guide d'onde latéral 32 dans la section absorbante saturable 13. Ainsi, le coupleur en pointe est situé dans la zone de couplage zc_{Iae/SA}, de sorte que la largeur du guide d'onde latéral 32 diminue jusqu'à une valeur nulle l_{Iae/SA}. La zone de couplage zc_{Iae/SA} correspond sensiblement à la zone de recouvrement vertical entre la section absorbante saturable 13 et le coupleur en pointe.

Les figures 6A à 6C illustrent des vues schématiques et partielles d'un dispositif laser impulsionnel 1 selon une variante de réalisation. Ici, le milieu semiconducteur 11 comporte, agencés longitudinalement suivant l'axe longitudinal X, une première section à gain 12, une section absorbante saturable 13, et une deuxième section à gain 12. Dans cet exemple, l'espacement vertical d_{L/ms} est égal à d_{Iae/SA} et à d_{Iai/G}.

Ces sections 12, 13 ne sont pas séparées physiquement les unes des autres, mais au contraire forment des zones d'un même plot semiconducteur. L'isolation électrique entre les sections deux à deux est obtenue ici par une échancrure 14 située à l'interface entre la section absorbante saturable 13 et chacune des sections à gain 12, au niveau de laquelle un dopage approprié est effectué, par exemple via une implantation de protons H⁺.

Comme mentionné précédemment, la longueur suivant l'axe X de la section absorbante saturable 13 est de préférence inférieure à la longueur cumulée des sections à gain 12, et est de préférence de l'ordre de 2 à 10% de cette longueur cumulée des sections à gain 12. La section absorbante saturable 13 présente ainsi un temps faible de saturation/désaturation, propice à l'émission d'impulsions laser de faible durée.

Par ailleurs, le milieu semiconducteur 11 peut comporter une pluralité de sections électriquement isolées les unes des autres, connectées chacune à une source de polarisation électrique. Le signe de la tension électrique appliquée à chacune des sections peut déterminer si la section considérée est une section à gain 12 ou une section absorbante saturable 13. De plus, l'intensité de la tension électrique appliquée peut correspondre au poids wᵢ appliqué au signal synaptique d'inhibition ou d'excitation.

Notons que le couplage optique entre le guide d'onde longitudinal 21 et le milieu semiconducteur 11 est ici un couplage de type supermode (type de couplage optique que l'on retrouve dans les lasers DFB) dans la mesure où le guide d'onde longitudinal 21 s'étendent continûment sous le milieu semiconducteur 11. En revanche, le guide d'onde latéral 32 comporte un coupleur en pointe, pour que le mode guidé passe progressivement du guide d'onde 32 dans la section absorbante saturable 13 (type de couplage optique que l'on retrouve dans les lasers DBR). Ce peut également être le cas pour le guide d'onde latéral 42 (non représenté ici).

Le guide d'onde longitudinal 21 présente une largeur I_{L/ms} de son arête 21.2 dans la zone de couplage avec le milieu semiconducteur 11. De préférence, la base 21.1 présente une largeur plus importante dans cette zone de couplage, ce qui peut contribuer à réduire le facteur de confinement Γ_{L/ms}.

Le guide d'onde latéral 32 présente ici un coupleur en pointe, de sorte que sa largeur l_{Iae/SA} qui diminue dans la zone de couplage jusqu'à une valeur nulle. De préférence, la base 32.1 présente une largeur qui diminue également dans la zone de couplage, ici également jusqu'à une valeur nulle, ce qui contribue à augmenter le facteur de confinement Γ_{Iae/SA}.

Compte tenu de ce qui a été explicité précédemment, on peut résumer le fonctionnement du déclenchement de la source laser 10 par le tableau ci-dessous, selon que la section absorbante saturable 13 est éclairée ou non par une impulsion optique d'excitation, et selon que la source laser 10 se trouve dans un régime d'excitabilité ou non :

| | Hors du régime d'excitabilité : g < g_{exc} | Régime d'excitabilité : g_{exc} ≤ g ≤ gₘₐₓ |
|---|---|---|
| Excitation : émission d'une impulsion d'excitation | Pertes optiques αₘᵢₙ < α < αₘₐₓ | Pertes optiques α ≤ αₘᵢₙ |
| | Pas de saturation => Etat intermédiaire | Saturation => Etat passant |
| | Pas d'impulsion laser | Emission impulsion laser |
| Pas d'excitation : pas émission d'une impulsion d'excitation | Pertes optiques αₘₐₓ < α | Pertes optiques αₘₐₓ < α |
| | Etat bloquant | Etat bloquant |
| | Pas d'impulsion laser | Pas d'impulsion laser |

On comprend que le non-régime d'excitabilité de la source laser 10 correspond notamment à deux situations. Une première situation correspond à la période réfractaire : le gain, sous l'effet du courant de pompe, progresse, mais n'a pas encore atteint une valeur notée g_{exc}. Dans ce cas, le gain n'est pas suffisant pour participer, avec l'impulsion optique d'excitation, à saturer la section absorbante saturable 13 et donc à permettre l'émission d'une impulsion laser. Une deuxième situation correspond à l'inhibition : la période réfractaire est terminée, mais l'impulsion optique d'inhibition provoque une diminution du gain qui passe en dessous de la valeur g_{exc} et donc provoque une sortie du régime d'excitabilité. Là aussi, le gain n'est plus suffisant pour participer à saturer la section absorbante saturable 13 et donc à permettre l'émission de l'impulsion laser.

On retrouve ainsi ce comportement des neurones physiologiques en termes d'excitabilité et en termes de période réfractaire. Le neurone reste au repos lorsqu'il n'est pas excité. Il n'émet pas de signal lorsqu'il est dans la période réfractaire (à la suite de l'émission d'un signal), et peut émettre un signal lorsqu'il est sorti de la période réfractaire et qu'il est excité par des signaux d'intensité suffisante. Le fonctionnement d'un tel dispositif laser impulsionnel 1 est décrit dans la demande de brevet FR3123163 A1.

Ainsi, le dispositif laser impulsionnel 1 selon l'invention comporte une source laser hybride de type III-V sur Si et est à déclenchement actif de manière 'tout optique'. Il reproduit effectivement les propriétés d'excitabilité et de période réfractaire des neurones physiologiques. Les signaux synaptiques d'excitabilité et d'inhibition sont ici des impulsions optiques transmises directement jusqu'aux sections 12, 13 du milieu semiconducteur 11 de la source laser 10, sans qu'ait lieu une conversion O/E. Ceci est permis par la configuration hybride de la source laser 10, où les guides d'onde latéraux 32, 42 sont intégrés dans le substrat photonique 20 sans pour autant être couplés optiquement à la cavité optique. On évite ainsi les inconvénients des neurones artificiels photoniques de l'art antérieur de type 'conversion O/E/O', notamment les inconvénients liés à la conversion O/E et à la présence des photodiodes. On évite également les inconvénients des neurones photoniques de l'art antérieur de type 'tout optique' tels que ceux liés à la nécessité d'inverser les impulsions à l'entrée du neurone photonique et ceux liés au contrôle strict de l'écart en fréquence entre les lasers maître et esclave. De plus, par le choix des largeurs des guides d'onde intégrés, on optimise le facteur de confinement des modes optiques, ce qui améliore les performances du dispositif laser impulsionnel 1.

Des modes de réalisation particuliers viennent d'être décrits. Différentes variantes et modifications apparaîtront à l'homme du métier.

## Revendications

1. Dispositif laser impulsionnel (1), comportant :
∘ une source laser (10) impulsionnelle, hybride de type III-V sur silicium, comportant :
• un milieu semiconducteur (11) comportant des puits quantiques, réalisé à base d'un composé III-V, situé dans une cavité optique définissant un axe longitudinal (X), et comportant au moins une section à gain (12) et au moins une section absorbante saturable (13) où les puits quantiques sont coplanaires ;
• un substrat photonique (20), réalisé à base de silicium, sur lequel repose le milieu semiconducteur (11), et dans lequel est situé un guide d'onde longitudinal (21) participant à définir la cavité optique et couplé optiquement au milieu semiconducteur (11) suivant l'axe longitudinal (X), le guide d'onde longitudinal (21) présentant une largeur I_{L/ms} et un espacement vertical d_{L/ms} vis-à-vis du milieu semiconducteur (11), dans une zone de couplage zc_{L/ms} avec le milieu semiconducteur (11), prédéfinis de sorte que le mode optique se propageant dans le guide d'onde longitudinal (21) présente un facteur de confinement Γ_{L/ms} dans les puits quantiques du milieu semiconducteur (11) ;
∘ au moins un dispositif optique de commande (30 ; 40), comportant :
• au moins une source émettrice (31 ; 41) adaptée à émettre au moins une impulsion optique de commande d'intensité prédéfinie ;
• au moins un guide d'onde latéral (32 ; 42),
- situé dans le substrat photonique (20),
- couplé optiquement à la section absorbante saturable (13) ou à la section à gain (12) pour transmettre l'impulsion optique de commande, de manière inclinée vis-à-vis de l'axe longitudinal (X) pour éviter un couplage optique avec la cavité optique, et
- présentant une largeur (l_{Iae/SA} ; l_{Iai/G}) ainsi qu'un espacement vertical (d_{Iae/SA}; d_{Iai/G}) vis-à-vis du milieu semiconducteur (11), dans une zone de couplage (zc_{Iae/SA}; zc_{Iai/G}) avec ladite section correspondante (13 ; 12), prédéfinis de sorte que le mode optique se propageant dans le guide d'onde latéral (32 ; 42) présente un facteur de confinement (Γ_{Iae/SA}; Γ_{Iai/G}) dans les puits quantiques de ladite section correspondante (13 ; 12) supérieure à Γ_{L/ms}.

2. Dispositif laser impulsionnel (1) selon la revendication 1, dans lequel le guide d'onde latéral (32 ; 42) est configuré de sorte que le facteur de confinement (Γ_{Iae/SA} ; Γ_{Iai/G}) associé au guide d'onde latéral (32 ; 42) présente un écart vis-à-vis du facteur de confinement Γ_{L/ms} au moins égal à 5%, voire à 8%, voire encore à 10%.

3. Dispositif laser impulsionnel (1) selon la revendication 1 ou 2, dans lequel le guide d'onde longitudinal (21) présente une largeur I_{L/ms} dans sa zone de couplage zc_{L/ms}, et le guide d'onde latéral (32 ; 42) présente une largeur (l_{Iae/SA}; l_{Iai/G}) dans sa zone de couplage (zc_{Iae/SA}; zc_{Iai/G}) inférieure à l_{L/ms}.

4. Dispositif laser impulsionnel (1) selon l'une quelconque des revendications 1 à 3, dans lequel le guide d'onde longitudinal (21) présente un espacement vertical d_{L/ms} dans sa zone de couplage zc_{L/ms} vis-à-vis des puits quantiques du milieu semiconducteur (11), et le guide d'onde latéral (32) présente un espacement vertical (d_{Iae/SA}; d_{Iai/G}) dans sa zone de couplage (zc_{Iae/SA}; zc_{Iai/G}) vis-à-vis des puits quantiques du milieu semiconducteur (11), où l'espacement vertical d_{L/ms} est supérieur ou égal à celui du guide d'onde latéral (32 ; 42).

5. Dispositif laser impulsionnel (1) selon l'une quelconque des revendications 1 à 4, dans lequel le guide d'onde longitudinal (21) et le guide d'onde latéral (32) sont des guides d'onde en arête formés d'une base (21.1 ; 32.1) et d'une arête (21.2 ; 32.2), la face inférieure (21.1 ; 32.1) du guide d'onde longitudinal (21) et celle du guide d'onde latéral (32) étant coplanaires.

6. Dispositif laser impulsionnel (1) selon l'une quelconque des revendications 1 à 5, dans lequel le guide d'onde longitudinal (21) s'étend continûment sous le milieu semiconducteur (11) ; ou dans lequel le guide d'onde latéral (32 ; 42) s'étend continûment sous la section correspondante (13 ; 12) ou comporte au moins un coupleur en pointe.

7. Dispositif laser impulsionnel (1) selon l'une quelconque des revendications 1 à 6, dans lequel le milieu semiconducteur (11) comporte au moins deux sections à gain (12) situées de part et d'autre de la section absorbante saturable (13).

8. Dispositif laser impulsionnel (1) selon l'une quelconque des revendications 1 à 7, dans lequel la section à gain (12) et la section absorbante saturable (13) sont des portions physiquement distantes l'une de l'autre, ou sont des zones d'un même plot que forme le milieu semiconducteur (11).

9. Dispositif laser impulsionnel (1) selon l'une quelconque des revendications 1 à 8, dans lequel ledit au moins un dispositif optique de commande est un dispositif optique d'excitation (30), la source émettrice (31) étant adaptée à émettre au moins une impulsion optique d'excitation d'intensité prédéfinie, et le guide d'onde latéral (32), dit d'excitation, est couplé optiquement à la section absorbante saturable (13), le mode optique se propageant dans le guide d'onde latéral (32) d'excitation présentant alors un facteur de confinement Γ_{Iae/SA} dans les puits quantiques de la section absorbante saturable supérieure à Γ_{L/ms}.

10. Dispositif laser impulsionnel (1) selon l'une quelconque des revendications 1 à 8, dans lequel ledit au moins un dispositif optique de commande est un dispositif optique d'inhibition (40), la source émettrice (41) étant adaptée à émettre au moins une impulsion optique d'inhibition d'intensité prédéfinie, et le guide d'onde latéral (42), dit d'inhibition, est couplé optiquement à la section à gain (12), le mode optique se propageant dans le guide d'onde latéral (42) d'inhibition présentant alors un facteur de confinement Γ_{Iai/G} dans les puits quantiques de la section à gain supérieure à Γ_{L/ms}.

11. Dispositif laser impulsionnel (1) selon les revendications 9 et 10, comportant un dispositif optique d'excitation (30) et un dispositif optique d'inhibition (40).

12. Dispositif laser impulsionnel (1) selon la revendication 11, comportant des atténuateurs d'intensité optique (2) disposés sur les guides d'onde latéraux (32, 42), et adaptés à diminuer l'intensité des impulsions optiques d'excitation et d'inhibition.

13. Réseau de neurones artificiels photoniques, comportant une pluralité de dispositifs laser impulsionnels selon la revendication 11 ou 12, dans lequel chaque source laser impulsionnelle (10) forme un neurone artificiel photonique, les neurones artificiels photoniques étant raccordés optiquement les uns aux autres.

14. Réseau de neurones artificiels photoniques selon la revendication 13, dans lequel un guide d'onde longitudinal (21) d'un dispositif laser impulsionnel forme un guide d'onde latéral d'excitation ou d'inhibition d'un autre dispositif laser impulsionnel.

15. Procédé d'utilisation d'un dispositif laser impulsionnel (1) selon l'une quelconque des revendications 11 ou 12, comportant les étapes suivantes :
∘ polarisation en direct de la section à gain (12) par un courant électrique d'une intensité constante prédéfinie de sorte que le gain g du milieu semiconducteur (11) atteigne une valeur maximale gₘₐₓ, et application d'une polarisation nulle ou en inverse de la section absorbante saturable (13) ;
∘ émission d'une impulsion optique d'excitation par le dispositif optique d'excitation (30), provoquant une émission d'une impulsion laser par la source laser impulsionnelle (10) si le gain est au moins égal à une valeur d'excitabilité g_{exc};
∘ émission d'une impulsion optique d'inhibition par le dispositif optique d'inhibition (40), empêchant l'émission d'une impulsion laser par une diminution de la valeur du gain en dessous de la valeur d'excitabilité g_{exc}.
